(19) Europäisches Patentamt
European Patent Office
Office européen des brevets

(11) **EP 2 764 531 B1**

(12) **FASCICULE DE BREVET EUROPEEN**

(45) Date de publication et mention
de la délivrance du brevet:
**20.11.2019 Bulletin 2019/47**

(51) Int Cl.:
***H01J 37/32*** *(2006.01)*    ***C23C 14/48*** *(2006.01)*
***H01L 21/223*** *(2006.01)*

(21) Numéro de dépôt: **12794358.7**

(22) Date de dépôt: **04.10.2012**

(86) Numéro de dépôt international:
**PCT/FR2012/000392**

(87) Numéro de publication internationale:
**WO 2013/057390 (25.04.2013 Gazette 2013/17)**

(54) **PROCÉDÉ DE COMMANDE D'UN IMPLANTEUR IONIQUE EN MODE IMMERSION PLASMA**

VERFAHREN ZUR STEUERUNG EINES PLASMAIMMERSIONS-IONENIMPLANTERS

CONTROL PROCESS OF A PLASMA IMMERSION ION IMPLANTER

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **06.10.2011 FR 1103032**

(43) Date de publication de la demande:
**13.08.2014 Bulletin 2014/33**

(73) Titulaire: **Ion Beam Services
13790 Peynier (FR)**

(72) Inventeurs:
• **TORREGROSA, Frank
F-13109 Simiane (FR)**
• **ROUX, Laurent
F-13013 Marseille (FR)**

(74) Mandataire: **Cabinet Prugneau-Schaub
Europole - Le Grenat
3, avenue Doyen Louis Weil
38000 Grenoble (FR)**

(56) Documents cités:
**WO-A1-01/15200        WO-A1-2007/013753
FR-A1- 2 871 812        FR-A1- 2 871 934
US-A1- 2007 069 157**

• **YUKIMURA K ET AL: "Two switch high voltage
modulator for plasma-based ion implantation",
SURFACE AND COATINGS TECHNOLOGY,
ELSEVIER, AMSTERDAM, NL, vol. 156, no. 1-3, 1
juillet 2002 (2002-07-01), pages 66-70,
XP002314548, ISSN: 0257-8972, DOI:
10.1016/S0257-8972(02)00114-7**

EP 2 764 531 B1

**Description**

La présente invention concerne un procédé de commande d'un implanteur ionique en mode immersion plasma.

Le domaine de l'invention est celui des implanteurs ioniques opérant en mode immersion plasma. Ainsi, l'implantation ionique d'un substrat consiste à l'immerger dans un plasma et à le polariser en tension négative, de quelques dizaines de Volts à quelques dizaines de kilovolts (généralement moins de 100 kV), ceci de façon à créer un champ électrique capable d'accélérer les ions du plasma vers le substrat de sorte qu'ils s'y implantent. Les atomes ainsi implantés sont dénommés dopants.

La profondeur de pénétration des ions est déterminée par leur énergie d'accélération. Elle dépend d'une part de la tension appliquée au substrat et d'autre part de la nature respective des ions et du substrat. La concentration d'atomes implantés dépend de la dose qui s'exprime en nombre d'ions par cm$^2$ et de la profondeur d'implantation.

Pour des raisons liées à la physique des plasmas, il se crée, en quelques nanosecondes après l'application de la tension, une gaine ionique autour du substrat. La différence de potentiel responsable de l'accélération des ions vers le substrat se retrouve aux bornes de cette gaine.

La croissance de cette gaine en fonction du temps suit l'équation de Child-Langmuir :

$$j_c = \frac{4}{9} \varepsilon_0 \left(\frac{2e}{M}\right)^{1/2} \frac{V_0^{3/2}}{s^2}$$

où :

  $j_c$ : densité de courant,
  $\varepsilon_0$ : permitivité du vide,
  $e$ : charge de l'ion,
  $M$ : masse de l'ion,
  $V_0$ : différence de potentiel au travers de la gaine, et
  $s$ : épaisseur de la gaine.

En stipulant que la densité de courant est égale à la charge traversant la limite de la gaine par unité de temps, ds/dt représente la vitesse de déplacement de cette limite :

$$\frac{ds}{dt} = \frac{2}{9} \frac{s_0^2 \cdot u_0}{s^2}$$

Expression dans laquelle $s_0$ vaut :

$$s_0 = \left(\frac{2\varepsilon_0 V_0}{e.n_0}\right)^{1/2}$$

étant entendu que $u_0 = (2eV_0 / M)$ est la vitesse caractéristique de l'ion et que $n_0$ est la densité du plasma.

L'épaisseur de la gaine est liée principalement à la tension appliquée, à la densité du plasma et à la masse des ions.

L'impédance équivalente du plasma qui conditionne le courant d'implantation est directement proportionnelle au carré de l'épaisseur de gaine. Le courant d'implantation décroît donc très rapidement lorsque la gaine augmente.

Au bout d'un certain laps de temps, il est nécessaire de procéder à une réinitialisation. Ceci s'avère pratiquement indispensable lorsque la gaine atteint les parois de l'enceinte stoppant ainsi le mécanisme d'implantation.

Afin de réinitialiser le système, la quasi-totalité des fabricants d'implanteurs arrête la haute tension sur le substrat tout en maintenant le plasma allumé. Il faut donc disposer d'un générateur pulsé qui produit des impulsions de haute tension.

Ainsi, en référence à la figure 1, le document WO 01/15200 propose de polariser le substrat au moyen d'une alimentation qui comporte :

- un générateur GEN dont le pôle positif est raccordé à la masse,
- un condensateur Ct en parallèle sur le générateur GEN,
- un premier interrupteur IT1 dont le premier pôle est raccordé au pôle négatif du générateur GEN et dont le second pôle est raccordé à la borne de sortie O de cette alimentation, et
- un deuxième interrupteur IT2 dont le premier pôle est raccordé à la borne de sortie O et dont le second pôle est raccordé à la masse.

Le procédé comporte les phases suivantes :

- phase d'implantation durant laquelle :

    ◦ l'alimentation plasma est activée,
    ◦ le premier interrupteur IT1 est fermé,
    ◦ le deuxième interrupteur IT2 est ouvert ;

- phase de neutralisation durant laquelle :

    ◦ le premier interrupteur IT1 est ouvert,
    ◦ le deuxième interrupteur IT2 est fermé.

La présence continue du plasma dans l'enceinte donne lieu à des effets secondaires indésirables :

- génération de particules,

- apport thermique au substrat,
- agression de l'enceinte en générant des risques de contamination métallique des pièces traitées,
- création d'effets de charge, particulièrement gênants dans le cas des applications microélectroniques, et
- implantation à tension d'accélération non stabilisée pendant les phases de montée et de descente de la tension appliquée au substrat.

Par ailleurs, le document US 2007/069157 prévoit la succession des opérations suivantes :

- activation de l'alimentation du substrat,
- après un certain délai, activation de l'alimentation du plasma pour la durée d'une impulsion,
- désactivation de l'alimentation du plasma,
- après une certaine période, désactivation de l'alimentation du substrat.

Il s'ensuit que durant ladite période, l'alimentation du substrat est activée et l'alimentation du plasma est désactivée, ce qui correspond à une phase de relaxation.

Durant la phase d'implantation, les zones du substrat qui sont électriquement isolantes se chargent positivement et ceci de manière cumulative. Il va sans dire que cette situation n'est pas souhaitable ne serait ce qu'en raison des perturbations apportées au processus d'implantation. Il est donc souhaitable de neutraliser ces charges positives en apportant des électrons.

On peut ainsi prévoir un filament, mais celui-ci tend à se vaporiser. On peut également prévoir un canon à électrons, mais il s'agit là d'un équipement additionnel relativement lourd.

L'invention a donc pour objet de faciliter la neutralisation des charges positives.

L'invention vise un procédé de commande d'un implanteur ionique tel que défini par la revendication 1, comportant une alimentation plasma et une alimentation substrat, cette alimentation substrat comprenant :

- un générateur électrique dont le pôle positif est raccordé à la masse,
- un premier interrupteur dont le premier pôle est raccordé au pôle négatif du générateur et dont le second pôle est raccordé à la borne de sortie de cette alimentation substrat,
- un deuxième interrupteur dont le premier pôle est raccordé à cette borne de sortie et dont le second pôle est relié à une borne de neutralisation,

procédé comportant une phase d'implantation durant laquelle :

- l'alimentation plasma est activée,
- le premier interrupteur est fermé,
- le deuxième interrupteur est ouvert,

procédé comportant aussi une phase de neutralisation durant laquelle :

- le premier interrupteur est ouvert,
- le deuxième interrupteur est fermé ;

procédé remarquable en ce que :

- comportant de plus une phase de relaxation qui chevauche la phase d'implantation et la phase de neutralisation, phase de relaxation durant laquelle l'alimentation plasma est inactivée,
- la phase de neutralisation comprend une étape préliminaire pour fermer le deuxième interrupteur, cette étape préliminaire étant suivie par une étape d'annulation pour activer l'alimentation plasma.

Ainsi, lors de l'étape d'annulation, les charges positives du substrat sont neutralisées par les électrons du plasma.

Avantageusement, l'étape d'annulation est suivie d'une étape d'inactivation pour désactiver l'alimentation plasma.

De préférence, l'étape d'inactivation est suivie d'une étape d'interruption pour ouvrir le deuxième interrupteur.

D'autre part, si la tension appliquée sur le substrat varie (à la hausse ou à la baisse) pendant que le plasma est allumé, les paramètres d'implantation varient en conséquence. C'est le cas notamment pour la profondeur de pénétration des dopants qui dépend directement de la tension d'accélération.

Ainsi, un second objet de la présente invention est de stabiliser les paramètres d'implantation.

Selon l'invention, la phase d'implantation comprend une étape d'initialisation pour fermer le premier interrupteur, cette étape d'initialisation étant suivie après une période de stabilisation par une étape d'activation pour activer l'alimentation plasma.

Il s'ensuit que le plasma est allumé après que la tension appliquée au porte-substrat soit stabilisée.

Suivant un mode de réalisation privilégié, l'étape d'activation est suivie d'une étape d'extinction pour désactiver l'alimentation plasma.

De plus, l'étape d'extinction est suivie d'une étape de pause pour ouvrir le premier interrupteur.

De la sorte, la tension appliquée au porte-substrat est maintenue constante pendant toute la période d'alimentation du plasma.

L'invention vise encore un implanteur ionique tel que défini par la revendication 7, qui comprend des moyens pour la mise en œuvre du procédé ci-dessus décrit.

La présente invention apparaîtra maintenant avec plus de détails dans le cadre de la description qui suit d'un exemple de réalisation donné à titre illustratif en se référant aux figures jointes parmi lesquelles :

- la figure 1 représente une alimentation haute tension selon l'état de l'art,
- la figure 2 représente un implanteur ionique pourvu d'un module de commande,
- la figure 3 représente une alimentation électrique haute tension selon l'invention, et
- la figure 4 représente un diagramme temporel schématisant le procédé de l'invention.

Les éléments présents sur plusieurs figures sont affectés d'une seule et même référence.

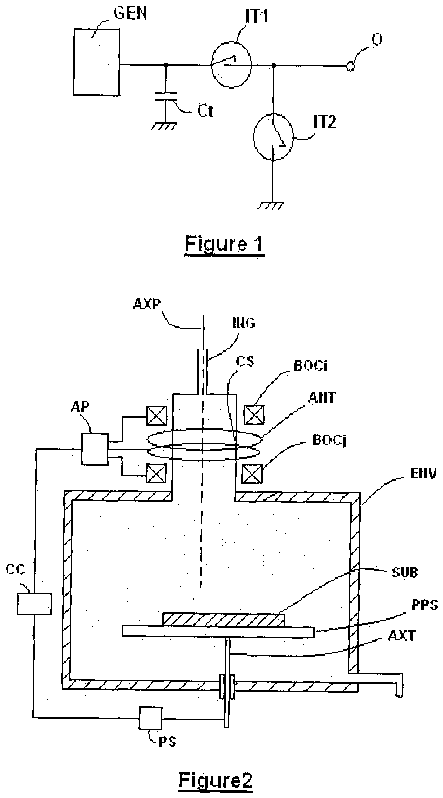

En référence à la figure 2, un implanteur ionique comporte plusieurs éléments agencés à l'intérieur et à l'extérieur d'une enceinte à vide ENV. Pour les applications microélectroniques, il est préconisé d'utiliser une enceinte en alliage d'aluminium si l'on souhaite limiter la contamination en éléments métalliques tels que Fer, Chrome, Nickel ou Cobalt. Un revêtement en silicium ou en carbure de Silicium peut aussi être utilisé.

Un plateau porte substrat PPS, se présentant sous la forme d'un disque à plan horizontal, mobile autour de son axe vertical AXT, reçoit le substrat SUB devant subir l'implantation ionique.

La partie supérieure de l'enceinte ENV reçoit le corps de source plasma CS, cylindrique, d'axe vertical AXP. Ce corps est en quartz. Il est extérieurement entouré, d'une part par des bobines de confinement BOCi, BOCj, et d'autre part par une antenne radiofréquence ANT extérieure. L'entrée de gaz plasmagène ING est coaxiale à l'axe vertical AXP du corps de source CS. Cet axe vertical AXP rencontre la surface du plateau porte substrat PPS sur lequel est disposé le substrat à implanter SUB.

Il est possible d'utiliser tout type de source plasma puisée : décharge, ICP (pour « Inductively Coupled Plasma » en anglais), Helicon, micro-ondes, arc. Ces sources doivent travailler à des niveaux de pression suffisamment faibles pour que le champ électrique créé entre le plateau PPS à haute tension et l'enceinte ENV à la masse n'allume pas un plasma de décharge qui vienne perturber le fonctionnement pulsé de la source.

Le module de commande de l'implanteur ionique comporte essentiellement trois éléments :

- une alimentation substrat PS pour fournir la haute tension au substrat SUB,
- une alimentation plasma AP pour alimenter l'antenne radiofréquence ANT et les bobines de confinement BOCi, BOCj,
- un circuit de contrôle CC pour piloter ces deux alimentations.

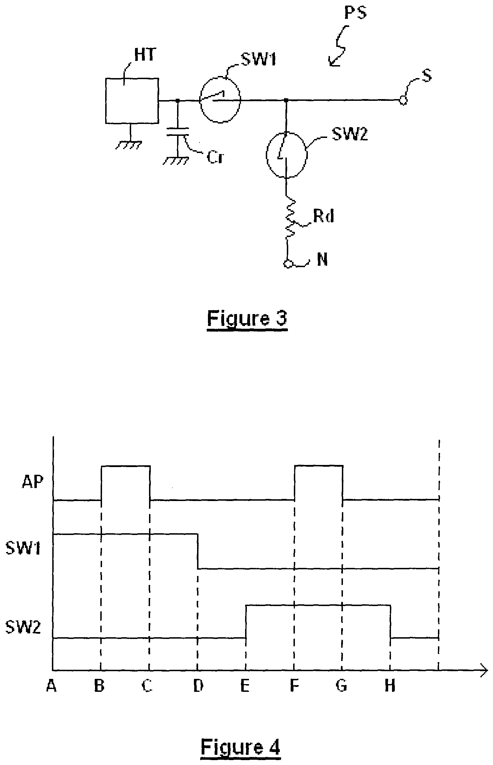

En référence à la figure 3, l'alimentation substrat PS comporte :

- un générateur haute tension HT dont le pôle positif est raccordé à la masse,
- un premier interrupteur SW1 dont le premier pôle est raccordé au pôle négatif du générateur HT et dont le second pôle est raccordé à la borne de sortie S de cette alimentation,
- un deuxième interrupteur SW2 dont le premier pôle est raccordé à la borne de sortie S et dont le second pôle est relié à une borne de neutralisation N soit directement, soit par l'intermédiaire d'une résistance de décharge Rd qui vaut typiquement 1 kΩ,
- de préférence, un condensateur de régulation Cr connecté en parallèle sur le générateur HT.

La borne de sortie S est raccordée au plateau porte-substrat PPS de l'implanteur.

La borne de neutralisation peut être raccordée à la masse. Elle peut également être raccordée au pôle positif d'une source de tension dont le pôle négatif est raccordé à la masse. Cette tension positive, généralement comprise entre 0 et 100 Volts, est avantageusement choisie sensiblement égale au potentiel plasma qui est souvent compris entre + 10 et + 20 Volts.

En référence à la figure 4, le circuit de contrôle CC pilote l'alimentation plasma AP et les deux interrupteurs SW1, SW2 de l'alimentation substrat PS comme suit.

Dans un état initial, ces trois éléments sont configurés de la manière suivante :

- alimentation plasma inactivée,
- premier interrupteur SW1 ouvert,
- deuxième interrupteur SW2 ouvert.

Au début d'un cycle, prend place la phase d'implantation qui débute par une étape d'initialisation représentée par le point A sur la figure 4.

Cette étape d'initialisation commence par la fermeture du premier interrupteur SW1. Elle s'étend sur une période de stabilisation qui vaut typiquement entre 1 μs et 5 μs.

A la suite de cette étape d'initialisation, vient une phase d'activation (point B sur la figure 4), étape durant laquelle l'alimentation plasma AP est activée. La durée de cette étape d'activation s'étend typiquement entre 5 μs et 100 μs.

Vient ensuite une étape d'extinction (point C sur la figure 4) au début de laquelle l'alimentation plasma AP est inactivée. Cette étape durant laquelle le plasma s'éteint dure typiquement de 20 μs à 200 μs. Elle met fin à la phase d'implantation.

Une étape de pause (point D sur la figure 4) commence par l'ouverture du premier interrupteur SW1 et se termine au début de la phase de neutralisation. Elle peut être relativement courte mais elle doit durer tant que le premier interrupteur SW1 n'est pas totalement ouvert et tant que le plasma n'est pas totalement éteint. Sa durée est donc supérieure à 0,1 μs et vaut typiquement entre 1 et 10 μs.

La phase de neutralisation commence avec une étape préliminaire (point E sur la figure 4) au début de laquelle le deuxième interrupteur SW2 est fermé. Cette étape préliminaire dure tant que la tension du plateau porte-substrat n'est pas revenue à la tension appliquée sur la borne de neutralisation N. Sa durée est typiquement comprise entre 1 μs et 40 μs.

Vient ensuite une étape d'annulation (point F sur la figure 4) durant laquelle l'alimentation plasma AP est activée. Les électrons du plasma sont attirés vers les zones du substrat qui sont chargés positivement et viennent neutraliser la charge. La durée de cette étape d'annulation est typiquement comprise entre 1 μs et 80 μs.

Vient ensuite une étape d'inactivation (point G sur la figure 4) au début de laquelle l'alimentation plasma est désactivée. La durée de cette étape vaut typiquement quelques dizaines de μs.

Le cycle se termine avec une étape d'interruption (point H sur la figure 4) qui commence avec l'ouverture du second interrupteur SW2. Cette étape d'interruption dure tant que ce second interrupteur n'est pas totalement ouvert et tant que le plasma n'est pas totalement éteint pour revenir à l'état initial.

Alors, un nouveau cycle peut être initié.

Il apparaît ainsi que la phase de relaxation (entre les points C et F sur la figure 4) durant laquelle l'alimentation plasma AP est inactivée chevauche la phase d'implantation et la phase de neutralisation.

L'exemple de réalisation de l'invention présenté ci-dessus a été choisi eu égard à son caractère concret. Il ne serait cependant pas possible de répertorier de manière exhaustive tous les modes de réalisation que recouvre cette invention. En particulier, toute étape ou tout moyen décrit peut être remplacé par une étape ou un moyen équivalent sans sortir du cadre de la présente invention L'invention est définie par les revendications.

**Revendications**

1. Procédé de commande d'un implanteur ionique comportant une alimentation plasma (AP) et une alimentation substrat (PS), cette alimentation substrat comprenant :

- un générateur électrique (HT) dont le pôle positif est raccordé à la masse,
- un premier interrupteur (SW1) dont le premier pôle est raccordé au pôle négatif dudit générateur (HT) et dont le second pôle est raccordé à la borne de sortie (S) de cette alimentation substrat,
- un deuxième interrupteur (SW2) dont le premier pôle est raccordé à ladite borne de sortie (S) et dont le second pôle est relié à une borne de neutralisation (N), le procédé comportant une phase d'implantation (A-D) durant laquelle
- ladite alimentation plasma est activée,
- ledit premier interrupteur (SW1) est fermé,
- ledit deuxième interrupteur (SW2) est ouvert, le procédé comportant aussi une phase de neutralisation (E-H) durant laquelle
- ledit premier interrupteur (SW1) est ouvert,
- ledit deuxième interrupteur (SW2) est fermé, le procédé étant **caractérisé :**

- **en ce qu'**il comporte de plus une phase de relaxation (C-F) qui chevauche ladite phase d'implantation et ladite phase de neutralisation, phase de relaxation durant laquelle ladite alimentation plasma (AP) est inactivée,
- **en ce que** ladite phase de neutralisation comprend une étape préliminaire (E-F) pour fermer ledit deuxième interrupteur (SW2), cette étape préliminaire étant suivie par une étape d'annulation (F-G) pour activer ladite alimentation plasma (AP).

2. Procédé selon la revendication 1, **caractérisé en ce que** ladite étape d'annulation (F-G) est suivie d'une étape d'inactivation (G-H) pour désactiver ladite alimentation plasma (AP).

3. Procédé selon la revendication 2, **caractérisé en ce que** ladite étape d'inactivation (G-H) est suivie d'une étape d'interruption pour ouvrir ledit deuxième interrupteur (SW2).

4. Procédé selon l'une quelconque des revendications précédentes, **caractérisé en ce que** ladite phase d'implantation comprend une étape d'initialisation (A-B) pour fermer ledit premier interrupteur, cette étape d'initialisation étant suivie après une période de stabilisation par une étape d'activation (B-C) pour activer ladite alimentation plasma.

5. Procédé selon la revendication 4, **caractérisé en ce que** ladite étape d'activation (B-C) est suivie d'une étape d'extinction (C-D) pour désactiver ladite alimentation plasma (AP).

6. Procédé selon la revendication 5, **caractérisé en ce que** ladite étape d'extinction (C-D) est suivie d'une étape de pause (D-E) pour ouvrir ledit premier interrupteur (SW1).

7. Implanteur ionique **caractérisé en ce qu'**il comprend des moyens pour la mise en œuvre du procédé selon l'une quelconque des revendications précédentes.

**Patentansprüche**

1. Verfahren zum Steuern eines Ionenimplanters, umfassend eine Plasmaversorgung (AP) und eine Substratversorgung (PS), diese Substratversorgung umfassend:

- einen elektrischen Generator (HT), dessen positiver Pol mit der Masse verbunden ist,
- einen ersten Schalter (SW1), dessen erster Pol mit dem negativen Pol des Generators (HT) verbunden ist und dessen zweiter Pol mit dem Ausgangsanschluss (S) dieser Substratversorgung verbunden ist,
- einen zweiten Schalter (SW2), dessen erster Pol mit dem Ausgangsanschluss (S) verbunden ist und dessen zweiter Pol mit einem Neutralanschluss (N) verbunden ist,

wobei das Verfahren eine Implantationsphase (A-D) umfasst, während der
- die Plasmaversorgung aktiviert ist,
- der erste Schalter (SW1) geschlossen ist,
- der zweite Schalter (SW2) geöffnet ist,

wobei das Verfahren auch eine Neutralisationsphase (E-H) umfasst, während der
- der erste Schalter (SW1) geöffnet ist,
- der zweite Schalter (SW2) geschlossen ist,

wobei das Verfahren **dadurch gekennzeichnet ist,**
- **dass** es überdies eine Relaxationsphase (C-F) umfasst, die die Implantationsphase und die Neutralisationsphase überlappt, während welcher Relaxationsphase die Plasmaversorgung (AP) inaktiviert ist,
- **dass** die Neutralisationsphase einen Einleitungsschritt (E-F) zum Schließen des zweiten Schalters (SW2) umfasst, welcher Einleitungsschritt gefolgt ist von einem Annullierungsschritt (F-G) zum Aktivieren der Plasmaversorgung (AP).

2. Verfahren nach Anspruch 1, **dadurch gekennzeichnet, dass** der Annullierungsschritt (F-G) gefolgt ist von einem Inaktivierungsschritt (G-H) zum Deaktivieren der Plasmaversorgung (AP).

3. Verfahren nach Anspruch 2, **dadurch gekennzeichnet, dass** der Inaktivierungsschritt (G-H) gefolgt ist von einem Schaltschritt zum Öffnen des zweiten Schalters (SW2).

4. Verfahren nach einem der vorhergehenden Ansprüche, **dadurch gekennzeichnet, dass** die Implantationsphase einen Initialisierungsschritt (A-B) zum Schließen des ersten Schalters umfasst, wobei dieser Initialisierungsschritt gefolgt ist, nach einem Stabilisierungszeitraum, von einem Aktivierungsschritt (B-C) zum Aktivieren der Plasmaversorgung.

5. Verfahren nach Anspruch 4, **dadurch gekennzeichnet, dass** der Aktivierungsschritt (B-C) gefolgt ist von einem Auslöschschritt (C-D) zum Deaktivieren der Plasmaversorgung (AP).

6. Verfahren nach Anspruch 5, **dadurch gekennzeichnet, dass** der Auslöschschritt (C-D) gefolgt ist von einem Pausenschritt (D-E) zum Öffnen des ersten Schalters (SW1).

7. Ionenimplanter, **dadurch gekennzeichnet, dass** er Mittel zum Anwenden des Verfahrens nach einem der vorhergehenden Ansprüche umfasst.

**Claims**

1. A method of controlling an ion implanter having a plasma power supply (AP) and a substrate power supply (PS), the substrate power supply comprising:

   • an electricity generator (HT) having its positive pole connected to ground;
   • a first switch (SW1) having its first pole connected to the negative pole of said generator (HT) and having its second pole connected to the output terminal (S) of said substrate power supply; and
   • a second switch (SW2) having its first pole connected to said output terminal (S) and having its second pole connected to a neutralization terminal (N);

   the method including an implantation stage (A-D) during which:

   • said plasma power supply is activated;
   • said first switch (SW1) is closed; and
   • said second switch (SW2) is opened;

   the method also including a neutralization stage (EH) during which:

   • said first switch (SW1) is opened; and
   • said second switch (SW2) is closed;

   the method being **characterized in that** it also includes a relaxation stage (C-F) that overlaps said implantation stage and said neutralization stage, in which relaxation stage said plasma power supply (AP) is inactivated; and
   **in that** said neutralization stage includes a preliminary step (E-F) for closing said second switch (SW2), said preliminary step being followed by a cancellation step (F-G) for activating said plasma power supply (AP).

2. A method according to claim 1, **characterized in that** said cancellation step (F-G) is followed by an inactivation step (G-H) for deactivating said plasma power supply (AP).

3. A method according to claim 2, **characterized in**

**that** said inactivation step (G-H) is followed by an interruption step of opening said second switch (SW2).

4. A method according to any preceding claim, **characterized in that** said implantation stage includes an initialization step (A-B) for closing said first switch, this initialization step being followed after a stabilization period by an activation step (B-C) for activating said plasma power supply.

5. A method according to claim 4, **characterized in that** said activation step (B-C) is followed by an extinction step (C-D) for deactivating said plasma power supply (AP).

6. A method according to claim 5, **characterized in that** said extinction step (C-D) is followed by a pause step (D-E) for opening said first switch (SW1).

7. An ion implanter **characterized in that** it includes means for implementing the method according to any preceding claim.

GEN

IT1

O

Ct

IT2

## Figure 1

AXP

ING

CS

AP

BOCi

AHT

BOCj

EHV

CC

SUB

PPS

AXT

PS

## Figure2

PS

HT

SW1

S

Cr

SW2

Rd

N

**Figure 3**

AP

SW1

SW2

A  B  C  D  E  F  G  H

**Figure 4**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 0115200 A

- US 2007069157 A